# EUROPEAN PATENT APPLICATION

(11) **EP 3 176 833 A1**
(43) Date of publication of application: **07.06.2017**
(21) Application number: 15827503.2
(22) Date of filing: 29.06.2015
(51) Int. Cl.: H01L 31/052, H02S 40/42

(54) **SOLAR CELL MODULE, METHOD FOR MANUFACTURING SAME AND SOLAR PHOTOVOLTAIC POWER GENERATION SYSTEM**

(30) Priority: 28.07.2014 JP 2014152916; 28.05.2015 JP 2015108706
(71) Applicant: Sharp Kabushiki Kaisha, Osaka 5908522 (JP)
(72) Inventor: IDE, Tetsuya, Sakai City, Osaka 590-8522 (JP); HIGASHI, Kenichi, Sakai City, Osaka 590-8522 (JP); KOIDE, Naoki, Sakai City, Osaka 590-8522 (JP); KAWASAKI, Osamu, Sakai City, Osaka 590-8522 (JP); UTSUMI, Hisayuki, Sakai City, Osaka 590-8522 (JP)
(74) Representative: Müller Hoffmann & Partner
(86) International application number: PCT/JP2015/068640
(87) International publication number: WO 2016/017341

(57) **Abstract**

Provided are a solar cell module, a method of manufacturing the solar cell module, and a photovoltaic power generation system including the solar cell module. The solar cell module includes a solar cell group in which a plurality of solar cells are arranged, and a first heat storage layer that is disposed on a rear surface side of the solar cell group. The first heat storage layer is a layer that contains 80% by weight or greater of a heat storage material including a first latent heat storage material having a phase change temperature of T₁. The solar cell module may further include a second heat storage layer, which includes a second latent heat storage material having a phase change temperature T₂ different from the phase change temperature T₁, on a rear surface side of the first heat storage layer.

## Description

### Technical Field

The present invention relates to a solar cell module and a method of manufacturing the solar cell module, and more particularly, to a solar cell module capable of appropriately suppressing temperature rising due to solar irradiation, and a method of manufacturing the solar cell module. In addition, the invention relates to a photovoltaic power generation system including the solar cell module.

### Background Art

A solar cell module is installed on a roof of a building or a house, and the like, and is directly exposed to sunlight. Accordingly, a temperature of the solar cell module rises to approximately 70°C in a time zone such as daytime in which solar irradiance is high. This is because it is difficult to cool the solar cell module with air cooling to catch up with a heat input due to solar irradiation, particularly, in the time zone in which the solar irradiance is high. When the temperature of the solar cell module excessively rises, photoelectric conversion efficiency deteriorates.

As a configuration for suppressing excessive temperature rising due to solar irradiation and cooling down the solar cell to an approximately constant temperature, Japanese Unexamined Patent Application Publication No. 2012-033812 (PTL 1) suggests the following configuration. Specifically, a heat transfer lattice in which a coolant composed of a porous material impregnated with a latent heat storage material is accommodated in a coolant accommodating section, or a cooling plate constituted by a porous material impregnated with the latent heat storage material is provided on a rear surface of the solar cell in order for the latent heat storage material to absorb heat that is transferred to the heat transfer lattice or the cooling plate.

### Citation List

### Patent Literature

PTL 1: Japanese Unexamined Patent Application Publication No. 2012-033812

### Summary of Invention

### Technical Problem

As described above, PTL 1 suggests a configuration in which a cooling member obtained by impregnating the latent heat transfer material into the porous material is provided on the rear surface of the solar cell. However, in a case of the method, there is a concern that a heat storage amount (endothermic amount) per unit volume of the cooling member is small in consideration of the configuration in which the porous material is impregnated with the latent heat storage material, and thus cooling efficiency is not sufficient.

Accordingly, an object of the invention is to provide a solar cell module capable of appropriately suppressing temperature rising due to solar irradiation, a method of manufacturing the solar cell module, and a photovoltaic power generation system including the solar cell module. Solution to Problem

The invention provides a solar cell module, a method of manufacturing the solar cell module, and a photovoltaic power generation system as described below.

(1) A solar cell module includes a solar cell group in which a plurality of solar cells are arranged, and a first heat storage layer that is disposed on a rear surface side of the solar cell group. The first heat storage layer is a layer that contains 80% by weight or greater of a latent heat storage material including a first latent heat storage material having a phase change temperature T₁.
(2) In the solar cell module according to (1), the phase change temperature T₁ may be 32°C to 37°C, or 45°C to 60°C.
(3) The solar cell module according to (1) may further include a second heat storage layer that is disposed on a rear surface side of the first heat storage layer. The second heat storage layer may include a second latent heat storage material having a phase change temperature T₂ different from the phase change temperature T₁, and the phase change temperature T₁ may be lower than the phase change temperature T₂.
(4) In the solar cell module according to (3), the phase change temperature T₁ may be 32°C to 37°C, and the phase change temperature T₂ may be 45°C to 60°C.
(5) In the solar cell module according to (1), the first heat storage layer may be a layer that contains the first latent heat storage material, and a third latent heat storage material having a phase change temperature T₃ different from the phase change temperature T₁.
(6) In the solar cell module according to (5), the phase change temperature T₁ may be lower than the phase change temperature T₃.
(7) In the solar cell module according to (1), the first latent heat storage material may be a gel-like heat storage material.
(8) In the solar cell module according to (7), the gel-like heat storage material may include a double-network gel or a nano-composite gel.
(9) In the solar cell module according to (1) or (2), the phase change temperature T₁ may be a temperature that is determined on the basis of an environment in which the solar cell module is installed and which includes an ambient temperature at a site where the solar cell module is installed.
(10) In the solar cell module according to (3) or (4), the phase change temperature T₂ may be a temperature that is determined on the basis of an environment in which the solar cell module is installed and which includes an ambient temperature at a site where the solar cell module is installed.
(11) In the solar cell module according to (5) or (6), the phase change temperature T₃ may be a temperature that is determined on the basis of an environment in which the solar cell module is installed and which includes an ambient temperature at a site where the solar cell module is installed.
(12) The solar cell module according to any one of (1) to (11) may further include a support structure that supports the solar cell module. The support structure may include a base portion that is embedded in the ground, and the first heat storage layer and the base portion may be capable of exchanging heat from each other.
(13) A method of manufacturing the solar cell module according to any one of (1) to (12) in which the first heat storage layer includes a gel-like heat storage material including a microgel, and the first latent heat storage material. The method includes a process of preparing a dried microgel obtained by drying the microgel, a process of transporting the dried microgel to a manufacturing site of the solar cell module, a process of preparing a gel-like heat storage material by mixing the dried microgel, the first latent heat storage material, and water at the manufacturing site, and a process of preparing a solar cell module by using the gel-like heat storage material.
(14) A photovoltaic power generation system includes the solar cell module according to any one of (1) to (12). Advantageous Effects of Invention

According to the aspects of the invention, it is possible to provide a solar cell module capable of appropriately suppressing temperature rising due to solar irradiation, a method of manufacturing the solar cell module, and a photovoltaic power generation system including the solar cell module.

### Brief Description of Drawings

[Fig. 1] Fig. 1 is a schematic sectional view illustrating an example of a solar cell module according to the invention.

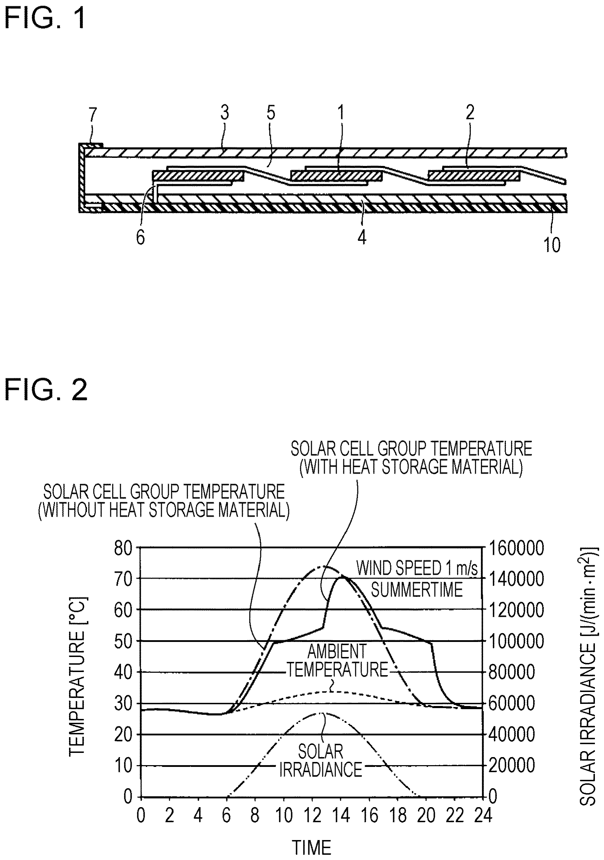

[Fig. 2] Fig. 2 is a view illustrating a comparison result between a temperature variation of a solar cell group for 24 hours in the solar cell module having a configuration provided with a first heat storage layer as illustrated in Fig. 1, and a temperature variation in a solar cell module having the same configuration as in Fig. 1 except that the first heat storage layer is not provided (a latent heat storage material: sodium disulfite pentahydrate, the thickness of the first heat storage layer: 10 mm, the amount of the latent heat storage material contained in the first heat storage layer: 100% by weight, a season: summer, and an average wind speed: 1 m/s).

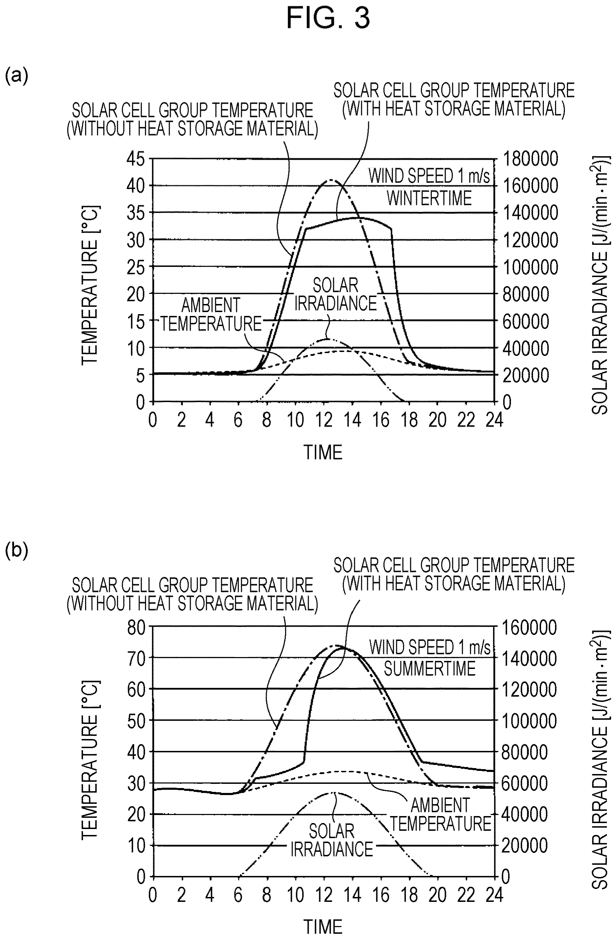

[Fig. 3] Fig. 3 is a view illustrating a comparison result between a temperature variation of the solar cell group for 24 hours in the solar cell module having the configuration provided with the first heat storage layer as illustrated in Fig. 1, and a temperature variation in a solar cell module having the same configuration as in Fig. 1 except that the first heat storage layer is not provided (a latent heat storage material: sodium sulfite decahydrate, the thickness of the first heat storage layer: 10 mm, the amount of the latent heat storage material contained in the first heat storage layer: 100% by weight, a season: winter in Fig. 3(a) and summer in Fig. 3(b), an average wind speed: 1 m/s, and a temperature difference between day and night: small).

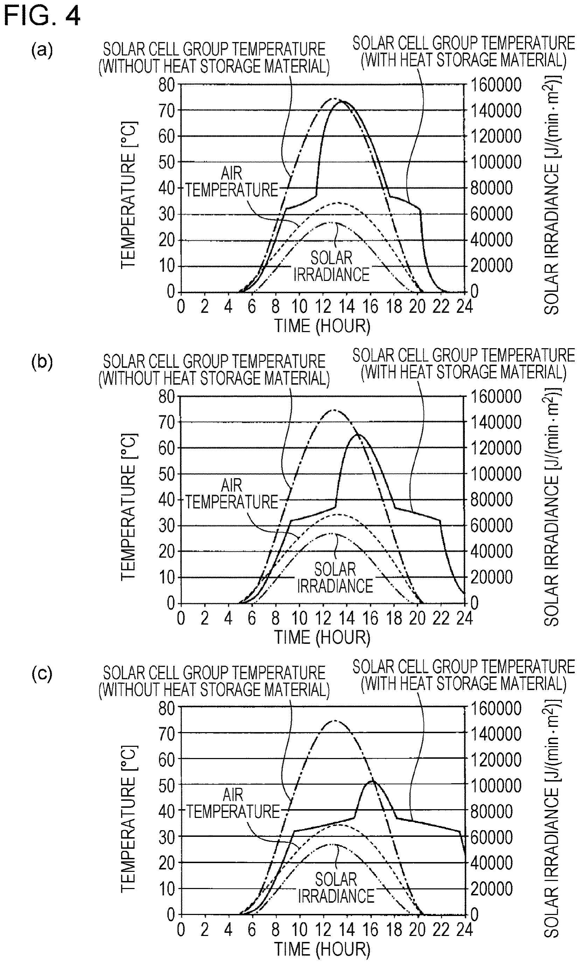

[Fig. 4] Fig. 4 is a view illustrating a comparison result between a temperature variation of the solar cell group for 24 hours in the solar cell module having the configuration provided with the first heat storage layer as illustrated in Fig. 1, and a temperature variation in a solar cell module having the same configuration as in Fig. 1 except that the first heat storage layer is not provided (a latent heat storage material: sodium sulfite decahydrate, the thickness of the first heat storage layer: 10 mm in Fig. 4(a), 20 mm in Fig. 4(b), and 30 mm in Fig. 4(c), the amount of the latent heat storage material contained in the first heat storage layer: 100% by weight in Fig. 4(a) to Fig. 4(c), a season: summer, an average wind speed: 1 m/s, and a temperature difference between day and night: large).
[Fig. 5] Fig. 5 is a schematic sectional view illustrating another example of the solar cell module according to the invention.
[Fig. 6] Fig. 6 is a schematic sectional view illustrating a heat storage layer of the solar cell module illustrated in Fig. 5 in a partially enlarged manner.

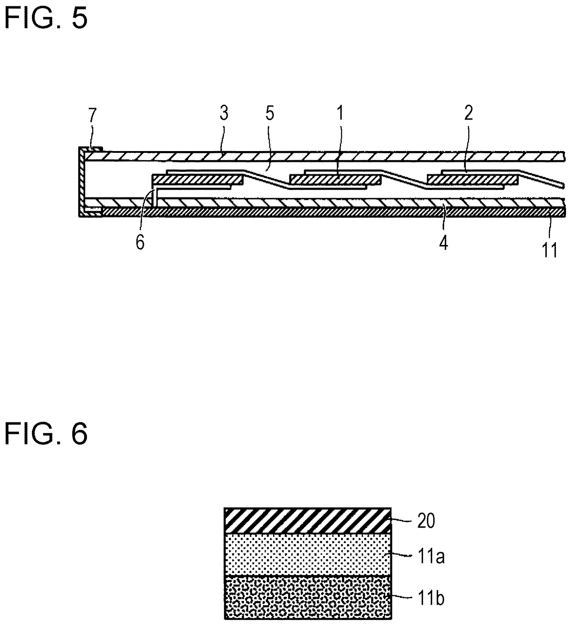

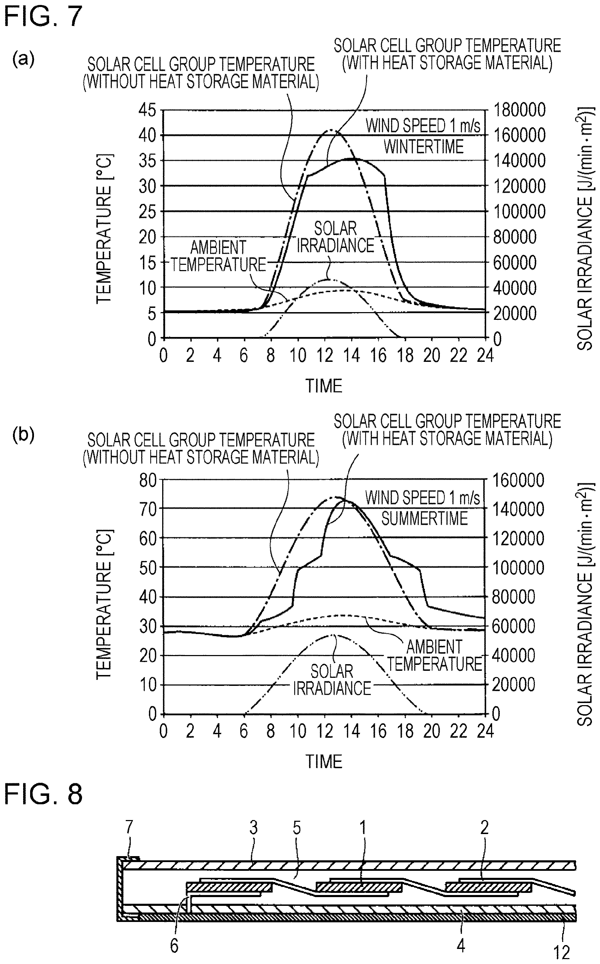

[Fig. 7] Fig. 7 is a view illustrating a comparison result between a temperature variation of the solar cell group for 24 hours in the solar cell module having a configuration provided with the heat storage layer having the two-layer structure as illustrated in Fig. 5, and a temperature variation in a solar cell module having the same configuration as in Fig. 5 except that the heat storage layer is not provided (a first latent heat storage material: sodium sulfite decahydrate, a second latent heat storage material: sodium disulfite pentahydrate, the thickness of the first heat storage layer and the second heat storage layer: 10 mm, the amount of the latent heat storage material contained in the first heat storage layer and the second heat storage layer: 100% by weight, a season: winter in Fig. 7(a) and summer in Fig. 7(b), an average wind speed: 1 m/s, and a temperature difference between day and night: small).
[Fig. 8] Fig. 8 is a schematic sectional view illustrating still another example of the solar cell module according to the invention.
[Fig. 9] Fig. 9 is a schematic sectional view illustrating the first heat storage layer of the solar cell module illustrated in Fig. 8 in a partially enlarged manner.
[Fig. 10] Fig. 10 is a schematic sectional view illustrating an example of the first latent heat storage material which can be used in a solar cell module according to a fifth embodiment.
[Fig. 11] Fig. 11 is a schematic sectional view illustrating an example of a support-structure-attached solar cell module according to an eighth embodiment.
[Fig. 12] Fig. 12 is a schematic view illustrating a configuration of a photovoltaic power generation system according to a ninth embodiment.
[Fig. 13] Fig. 13 is a schematic view illustrating an example of a configuration of a solar cell module array illustrated in Fig. 12.
[Fig. 14] Fig. 14 is a schematic view illustrating a configuration of a photovoltaic power generation system according to a tenth embodiment.

### Description of Embodiments

### (Solar Cell Module)

A solar cell module according to the invention includes at least a photovoltaic cell group in which a plurality of solar cells are arranged, and a first heat storage layer that is disposed on a rear side of the photovoltaic cell group. When the first heat storage layer is disposed on the rear surface, it is possible to appropriately suppress temperature rising due to solar irradiation in the solar cell module (photovoltaic cell group). Hereinafter, the solar cell module of the invention will be described in detail with reference to embodiments.

### <First Embodiment>

Fig. 1 is a schematic sectional view illustrating the solar cell module according to this embodiment. The solar cell module illustrated in Fig. 1 includes: a solar cell group in which a plurality of solar cells 1 are arranged lengthwise and crosswise, for example, on the same plane; a front cover 3 that is disposed on a front surface (light-receiving surface) side of the solar cell group; a back cover 4 that is disposed on a rear surface side of the solar cell group; a filling material 5 that is used to fill a space between the front cover 3 and the back cover 4 so as to seal the solar cell group; a first heat storage layer 10 that is disposed on a rear surface side of the back cover 4 and includes a first latent heat storage material; and a frame 7 that is mounted to a side edge of the solar cell module. In the solar cell group, the solar cells 1 are electrically connected to each other by an interconnection 2. For example, the solar cell group is electrically connected to an output terminal (not illustrated) accommodated in a terminal box (not illustrated), which is disposed on a rear surface side of the solar cell group, through a wire 6.

Note that Fig. 1 illustrates an example of the configuration of the solar cell module, and the configuration of the solar cell module of the invention except the first heat storage layer 10 may be any one of configurations of the solar cell module that is known in the related art. In addition, the solar cell module of the invention may include constituent elements which are not illustrated in Fig. 1 when necessary. For example, a seal layer may be provided between an end surface formed by the front cover 3, the filling material 5, and the back cover 4, and the frame 7 to seal the end surface.

As illustrated in Fig. 1, the solar cell module according to this embodiment includes the first heat storage layer 10 that is disposed on a rear surface side of the solar cell group and contains 80% by weight or greater of a first latent heat storage material. The first latent heat storage material is a material that has a phase change temperature T₁ (°C), and performs heat storage by using latent heat during phase change. The phase change is typically phase change between a solid and a liquid, and the phase change temperature is typically a melting point (solidifying point). When the first heat storage layer 10, which contains the first latent heat storage material in a high concentration, is provided, it is possible to absorb heat from a solar cell group heated by solar irradiation, and thus it is possible to appropriately suppress temperature rising of the solar cell module. The heat, which is absorbed and stored by the first latent heat storage material, can be dissipated, for example, at night, and thus daily use is possible.

The first heat storage layer 10 may be a layer that is constituted by only the first latent heat storage material, or may be a layer that further includes another component. Examples of the other component include a thermoplastic resin or the like. The first heat storage layer 10 has, for example, 1) a configuration in which an exterior package such as a container or a film pack which is constituted by a thermoplastic resin or another material is filled with the first latent heat storage material, 2) a configuration in which the first latent heat storage material that is capsulated is dispersed in a resin or a gel, or 3) a configuration including the first latent heat storage material that is a gel-like heat storage material (a heat storage material to form a gel during phase change due to heat absorption). Among these, the configurations of 2) and 3) are preferable because an arrangement position of the heat storage material is fixed regardless of an orientation of a solar cell module when the solar cell module is installed. In addition, the configuration of 3) is preferable from the viewpoint of securing a relatively large endothermic amount.

For example, the first heat storage layer 10 may be a continuous layer that is formed to extend over a rear surface side of the solar cell module, but the solar cell module may include partially a region in which the first heat storage layer 10 is not provided on the rear surface side. However, it is preferable that the first heat storage layer 10 exists at least immediately below the solar cell 1 from the viewpoint of efficiency of heat absorption from the solar cell 1. For example, the thickness of the first heat storage layer 10 may be approximately 0.1 to 100 mm.

As illustrated in Fig. 1, the first heat storage layer 10 may be laminated on a rear surface of the back cover 4. At this time, it is preferable to lower thermal contact resistance between the back cover 4 and the first heat storage layer 10 so as to raise heat conduction efficiency (furthermore, a temperature-rising suppressing effect) with respect to heat conducted from the solar cell 1 to the first heat storage layer 10. The thermal contact resistance is preferably 1×10⁻² m²·K/W or less. Examples of a method of reducing the thermal contact resistance include a method of raising a contact pressure between the back cover 4 and the first heat storage layer 10, and a method of joining the back cover 4 and the first heat storage layer 10 through a thermal-contact-resistance reducing layer such as a heat conductive sheet (for example, a sheet constituted by an elastomer material), a heat conductive tape, a layer constituted by a heat conductive gel, a layer constituted by a heat conductive adhesive, and a layer constituted by heat conductive grease.

The first latent heat storage material, which is contained in the first heat storage layer 10, is not particularly limited, and examples thereof include hydrates of inorganic salts such as sodium disulfite pentahydrate, sodium sulfite decahydrate, calcium chloride tetrahydrate or hexahydrate, sodium acetate trihydrate, and barium hydroxide octahydrate. In addition, other heat storage materials as illustrated in other embodiments described later may be used.

The heat change temperature T₁ (typically, the melting point) of the first latent heat storage material is appropriately set in correspondence with an environment in which the solar cell module is installed. This will be described in detail in another embodiment to be described later. For example, in a case where the heat change temperature T₁ is the melting point (solidifying point), it is preferable that T₁ is higher than the highest ambient temperature at night (preferably, the highest ambient temperature at night in summer) so that the first latent heat storage material returns to a solid state through heat dissipation at night. In addition, it is preferable that T₁ is lower than the highest temperature of the solar cell group, which is reached in daytime (preferably, the highest temperature of the solar cell group, which is reached in daytime, in winter), so that the first latent heat storage material absorbs heat of the solar cell 1.

The front cover 3, the back cover 4, the filling material 5, and the frame 7 may be made of typical materials of the related art. For example, a resin or glass is used for the front cover 3 and the back cover 4, a resin (thermosetting resin or the like) is used for the filling material, and a metal or an alloy (aluminum or the like) is used for the frame 7.

### <Second Embodiment>

A configuration of a solar cell module of this embodiment is the same as in the first embodiment except that the heat change temperature T₁ of the first latent heat storage material contained in the first heat storage layer 10 is more strictly designed in consideration of the environment in which the solar cell module is installed. The heat change temperature T₁ may be determined in correspondence with, particularly, the effect of suppressing temperature rising of the solar cell module is desired to be obtained at which period of time in the year in consideration of the environment in which the solar cell module is installed such as an ambient temperature at a site where the solar cell module is installed. Examples are as follows.

(a) In a case of preferentially suppressing the temperature rising in summer in which the temperature of the solar cell module becomes the highest through a year, it is preferable that T₁ is higher than the highest ambient temperature in daytime so that the first latent heat storage material can exist in a solid state at the highest ambient temperature in daytime in summer. In addition, it is preferable that T₁ is lower than the highest temperature of the solar cell group which is reached in daytime in summer so that the first latent heat storage material absorbs heat of the solar cell 1.
   The highest temperature of the solar cell group that is mentioned here depends on an average wind speed at the installation site, and has a tendency that the greater the average wind speed is, the lower the highest temperature of the solar cell group is. More specifically, for example, in a case of an approximately windless state (the average wind speed is approximately 1 m/s or less), the highest temperature of the solar cell group in summer may reach to a temperature of 70°C or higher. However, in a case where wind exists to a certain degree, for example, in a case where the average wind speed is approximately 4 m/s, the highest temperature of the solar cell group in summer may become approximately 60°C. Accordingly, it is preferable to select T₁ to be lower than the highest temperature of the solar cell group at the average wind speed, in consideration of the average wind speed at the installation site.
   In a case of preferentially suppressing temperature rising in summer, it is preferable T₁ is approximately 40°C to 65°C, more preferably 45°C to 60°C, and still more preferably 45°C to 55°C (for example, 55°C) in consideration of the above-described situation. Examples of the latent heat storage material having a phase change temperature in this range include: sodium disulfite pentahydrate (melting point: 50°C, latent heat: 197 kJ/kg); NaCH₃COO-3H₂O (melting point: 58°C, latent heat: 264 kJ/kg); an inorganic eutectic material such as Mg(NO₃)₂·6H₂O/Mg (NO₃)₂·2H₂O (melting point: 55.5°C, latent heat: 151 kJ/kg); organic paraffins such as n-Docosane (melting point: 44°C, latent heat: 157 kJ/kg), n-Tetracosane (melting point: 50.6°C, latent heat: 162 kJ/kg), and n-Hexacosane (melting point: 56.3°C, latent heat: 162 kJ/kg); and other organic materials such as propionamide/palmitic acid (melting point: 50°C, latent heat: 192 kJ/kg), camphene (melting point: 50°C, latent heat: 238 kJ/kg), and myristic acid (melting point: 57°C, latent heat: 197 kJ/kg).
   Fig. 2 is a view illustrating a comparison result between a temperature variation of a solar cell group for 24 hours in the solar cell module having the configuration provided with the first heat storage layer 10 as illustrated in Fig. 1, and a temperature variation in a solar cell module having the same configuration as in Fig. 1 except that the first heat storage layer 10 is not provided. Fig. 2 illustrates a result under conditions in which sodium disulfite pentahydrate is used as the first latent heat storage material, the thickness of the first heat storage layer 10 is set to 10 mm, a season is summer, and an average wind speed is 1 m/s). Fig. 2 illustrates a variation of an ambient temperature and a variation of solar irradiance for 24 hours in combination with the result. The result shows that when the first heat storage layer 10 is provided, temperature rising of the solar cell module is effectively suppressed, particularly, in a time zone in which the solar irradiance becomes peak.
(b) In a case of obtaining the effect of suppressing temperature rising of the solar cell module over a year both in summer and in winter, it is preferable that T₁ is higher than the highest ambient temperature at night in summer so that the first latent heat storage material returns to a solid state through heat dissipation at night even in summer. As is the case with (a), it is preferable that T₁ is lower than the highest temperature of the solar cell group, which is reached in daytime in summer, so that the first latent heat storage material can absorb heat of the solar cell 1. Further, it is preferable that T₁ is lower than the highest temperature of the solar cell group, which is reached in daytime in winter, so as to obtain the effect of suppressing temperature rising of the solar cell module even in winter.

In consideration of the above-described situations, in a case of obtaining the effect of suppressing temperature rising of the solar cell module both in summer and in winter, T₁ may be approximately 30°C to 40°C (for example, equal to or higher than 30°C and lower than 40°C), and it is preferable that T₁ is approximately 32°C to 37°C (for example, 35°C). Examples of the latent heat storage material having the phase change temperature in this range include: a hydrate of an inorganic salt such as sodium sulfite decahydrate (melting point: 32°C, latent heat: 251 kJ/kg) and Na₂HPO₄·12H₂O (melting point: 35.2°C, latent heat: 281 kJ/kg); a hydrate of an inorganic nitrate such as Zn(NO₃)₂·6H₂O (melting point: 36°C, latent heat: 147 kJ/kg); and organic paraffins such as n-Eicosane (melting point: 36.4°C, latent heat: 247 kJ/kg).

Fig. 3 is a view illustrating a comparison result between a temperature variation of the solar cell group for 24 hours in the solar cell module having the configuration provided with the first heat storage layer 10 as illustrated in Fig. 1, and a temperature variation in a solar cell module having the same configuration as in Fig. 1 except that the first heat storage layer 10 is not provided. Fig. 3 illustrates a result under conditions in which sodium sulfite decahydrate is used as the first latent heat storage material, the thickness of the first heat storage layer 10 is set to 10 mm, a season is winter in Fig. 3(a) and summer in Fig. 3(b), and an average wind speed is 1 m/s. Figs. 3(a) and 3(b) illustrate a variation of an ambient temperature and a variation of solar irradiance for 24 hours in combination with the result. The result shows that when the first heat storage layer 10 is provided, temperature rising of the solar cell module is effectively suppressed both in summer and in winter, particularly in winter, in a time zone in which the solar irradiance becomes peak, or before and after the time zone.

### <Third Embodiment>

A configuration of a solar cell module of this embodiment is the same as in the first embodiment except that as is the case with the second embodiment, the heat change temperature T₁ of the first latent heat storage material contained in the first heat storage layer 10 is more strictly designed in consideration of the environment in which the solar cell module is installed. Particularly, in this embodiment, the heat change temperature T₁ is set with focus given to a temperature difference between day and night at the installation site.

Specifically, when the thickness of the first heat storage layer 10 is increased, it is possible to increase an endothermic amount. However, heat dissipation at night becomes slow, and thus if a temperature difference between day and light at the installation site of the solar cell module is relatively small, it is difficult to perform sufficient heat dissipation at night. As a result, the effect of suppressing temperature rising may not be obtained the next day and thereafter. However, in a case where the temperature difference between day and night at the installation site of the solar cell module is relatively great, it is possible to perform sufficient heat dissipation at night even in the same first latent heat storage material or even when the thickness of the first heat storage layer 10 is increased. As a result, it is possible to obtain the effect of suppressing temperature rising every day.

Fig. 4 is a view illustrating a comparison result between a temperature variation of the solar cell group for 24 hours in the solar cell module having the configuration provided with the first heat storage layer 10 as illustrated in Fig. 1, and a temperature variation in a solar cell module having the same configuration as in Fig. 1 except that the first heat storage layer 10 is not provided. Fig. 4 illustrates a result under conditions in which sodium sulfite decahydrate is used as the first latent heat storage material, the thickness of the first heat storage layer 10 is set to 10 mm (Fig. 4(a)), 20 mm (Fig. 4(b)), and 30 mm (Fig. 4(c)), a season is summer, and an average wind speed is 1 m/s. Figs. 4(a) to 4(c) illustrate a variation of an ambient temperature and a variation of solar irradiance for 24 hours in combination with the result. As can be seen from the graph of the ambient temperature, a temperature difference between day and night at the installation site of the solar cell module is greater than a temperature difference in Fig. 3(b). The drawings show that, even when the thickness of the first heat storage layer 10 is increased to 30 mm, a high temperature-rising suppressing effect is obtained. In addition, it is confirmed that the same temperature-rising suppressing effect is obtained everyday.

<Fourth Embodiment>

Fig. 5 is a schematic sectional view illustrating a solar cell module according to this embodiment, and Fig. 6 is a schematic sectional view illustrating a heat storage layer 11 of the solar cell module illustrated in Fig. 5 in a partially enlarged manner. The solar cell module according to this embodiment has the same configuration as in the first embodiment except that the heat storage layer 11 has a two-layer structure including a first heat storage layer 11a and a second heat storage layer 11b. The first heat storage layer 11a is a layer that contains 80% by weight or greater of a first latent heat storage material similar to the first heat storage layer 10 in the first embodiment, and the second heat storage layer 11b is a layer that contains a second latent heat storage material having a phase change temperature T₂ different from the phase change temperature T₁ of the first latent heat storage material. A layer, which is interposed between the back cover 4 and the first heat storage layer 11a, is a thermal-contact-resistance reducing layer 20 that is described in the first embodiment.

The second heat storage layer 11b is disposed on a rear surface side of the first heat storage layer 11a, and preferably contains 80% by weight or greater of the second latent heat storage material. However, the first heat storage layer 11a may be disposed on a rear surface side of the second heat storage layer 11b. The second latent heat storage material is a material that has the phase change temperature T₂ (°C) and performs heat storage by using latent heat during phase change. The phase change is typically phase change between a solid and a liquid, and the phase change temperature is typically a melting point (solidifying point).

The first heat storage layer 11a may be a layer that is constituted by only the first latent heat storage material, or may be a layer that further includes another component. In addition, the second heat storage layer 11b may be a layer that is constituted by only the second latent heat storage material, or may be a layer that further includes another component. Examples of the other component include a thermoplastic resin and the like. As the specific configuration of the first heat storage layer 11a and the second heat storage layer 11b which constitute the heat storage layer 11, description for the first heat storage layer 10 in the first embodiment is quoted. In a case where the first heat storage layer 11a and the second heat storage layer 11b are gel-like heat storage materials, it is preferable that a layer such as a resin layer or another film, which is capable of preventing migration of ions, is interposed at least at an interface between the first heat storage layer 11a and the second heat storage layer 11b so as to prevent migration of the ions between the layers.

For example, the heat storage layer 11 having a laminated structure may be a continuous layer that is formed to extend over a rear surface side of the solar cell module, but the solar cell module may include partially a region in which the heat storage layer 11 is not provided on the rear surface side. However, it is preferable that the heat storage layer 11 exists at least immediately below the solar cell 1 from the viewpoint of efficiency of heat absorption from the solar cell 1. For example, the thickness of the heat storage layer 11 may be approximately 0.1 to 100 mm. In addition, for example, the thickness of each of the first heat storage layer 11a and the second heat storage layer 11b may be approximately 0.1 to 70 mm.

When the heat storage layer 11 having the laminated structure of the first heat storage layer 11a and the second heat storage layer 11b is provided, it is possible to obtain the effect of appropriately suppressing temperature rising of the solar cell module both in summer and in winter (that is, over a year). That is, in a case where the heat storage layer 11 has a single-layer structure including the first latent heat storage material having the phase change temperature T₁ of approximately 40°C to 65°C as described in (a) of the second embodiment, it is possible to preferentially suppress temperature rising in summer. On the other hand, the temperature-rising suppressing effect in winter is not so great. In addition, in a case where the heat storage layer 11 has the single-layer structure including the first latent heat storage material having the phase change temperature T₁ of approximately 30°C to 40°C (for example, equal to or greater than 30°C and lower than 40°C) as described in (b) of the second embodiment, it is possible to obtain the temperature-rising suppressing effect both in summer and in winter (that is, over a year), but the temperature-rising suppressing effect in summer is not so great. In contrast, according to the heat storage layer 11 having the laminated structure of the first heat storage layer 11a and the second heat storage layer 11b, it is possible to obtain high temperature-rising suppressing effect both in summer and winter (that is, over a year).

In an example of this embodiment, only the first heat storage layer 11a substantially plays a role of absorbing heat in winter, and both of the first heat storage layer 11a and the second heat storage layer 11b play a role of absorbing heat in summer.

The phase change temperature T₁ of the first latent heat storage material contained in the first heat storage layer 11a may be approximately 30°C to 40°C (for example, equal to or higher than 30°C and lower than 40°C), and preferably approximately 32°C to 37°C (for example, 35°C). Specific examples of the latent heat storage material having the phase change temperature in this range are as described above.

The phase change temperature T₂ of the second latent heat storage material contained in the second heat storage layer 11b may be approximately 40°C to 65°C, and preferably approximately 45°C to 60°C, and still more preferably approximately 45°C to 55°C (for example, 55°C). Specific examples of the latent heat storage material having the phase change temperature in this range are as described above.

As described above, in a case of the two-layer structure including the first heat storage layer 11a and the second heat storage layer 11b, it is preferable that the phase change temperatures T₁ and T₂ are set to temperatures different from each other, and more preferably temperatures satisfying a relationship of T₁ < T₂. In addition, as is the case with the second and third embodiments, it is preferable that T₁ and T₂ are appropriately selected on the basis of an environment in which the solar cell module is installed such as the ambient temperature at a site at which the solar cell module is installed, a temperature difference between day and night at the installation site, and an average wind speed. For example, it is preferable that T₁ and T₂ are higher than the highest ambient temperature at night in summer so that the first heat storage layer 11a and the second heat storage layer 11b return to a solid state at night through heat dissipation even in summer.

In addition, as is the case with (b) in the second embodiment, it is preferable that T₁ is lower than the highest temperature of the solar cell group, which is reached in daytime in summer, so that the first latent heat storage material can absorb heat of the solar cell 1. Further, it is preferable that T₁ is lower than the highest temperature of the solar cell group, which is reached in daytime in winter, so as to obtain the effect of suppressing temperature rising of the solar cell module even in winter. In addition, as is the case with (a) of the second embodiment, it is preferable that T₂ is lower than the highest temperature of the solar cell group, which is reached in daytime in summer, so that the second latent heat storage material can absorb heat of the solar cell 1.

Fig. 7 is a view illustrating a comparison result between a temperature variation of the solar cell group for 24 hours in the solar cell module having a configuration provided with the heat storage layer 11 having the two-layer structure as illustrated in Fig. 5, and a temperature variation in a solar cell module having the same configuration as in Fig. 5 except that the heat storage layer 11 is not provided. Fig. 7 illustrates a result under conditions in which sodium sulfite decahydrate is used as the first latent heat storage material of the first heat storage layer 11a, sodium disulfite pentahydrate is used as the second latent heat storage material of the second heat storage layer 11b, the thickness of each of the first heat storage layer 11a and the second heat storage layer 11b is set to 10 mm, a season is winter in Fig. 3(a) and summer in Fig. 3(b), and an average wind speed is 1 m/s. Figs. 7(a) and Fig. 7(b) also illustrate a variation of an ambient temperature and a variation of solar irradiance for 24 hours in combination with the result. When the heat storage layer 11 having the two-layer structure is provided, as can be seen from the comparison with Fig. 3, it is possible to appropriately suppress temperature rising of the solar cell module both in summer and in winter in a time zone in which the solar irradiance becomes peak, or before and after the time zone.

### <Fifth Embodiment>

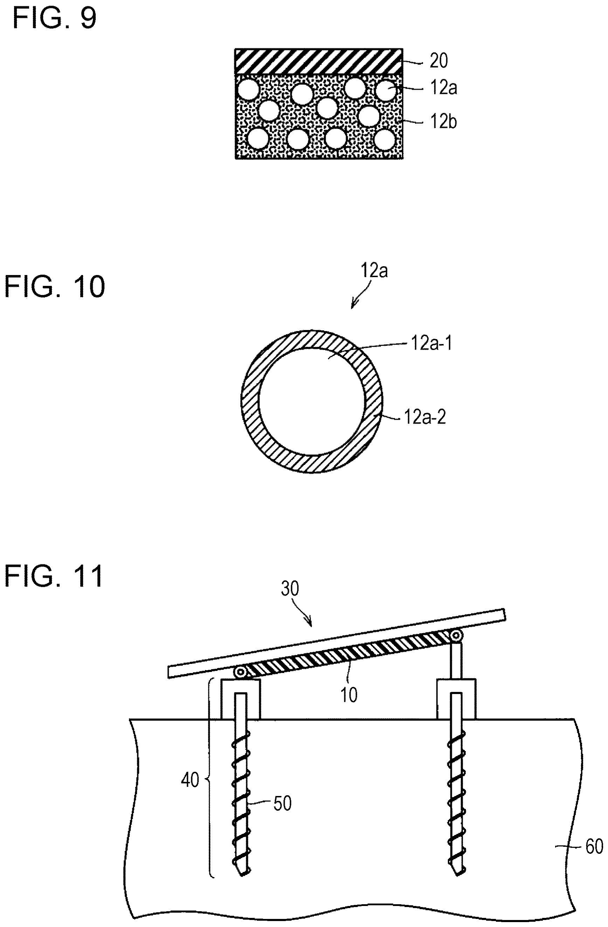

Fig. 8 is a schematic sectional view illustrating a solar cell module according to this embodiment, and Fig. 9 is a schematic sectional view illustrating a first heat storage layer 12 of the solar cell module illustrated in Fig. 8 in a partially enlarged manner. The solar cell module according to this embodiment has the same configuration as in the first embodiment except that the first heat storage layer 12 includes two kinds of latent heat storage materials including a first latent heat storage material 12a and a third latent heat storage material 12b. The first heat storage layer 12 is a layer containing 80% by weight or greater of latent heat storage material (the sum of the first latent heat storage material 12a and the third latent heat storage material 12b). A layer, which is interposed between the back cover 4 and the first heat storage layer 12, is the thermal-contact-resistance reducing layer 20 that is described in the first embodiment.

The first latent heat storage material 12a and the third latent heat storage material 12b are materials which respectively have phase change temperatures T₁ (°C) and T₃ (°C) and perform heat storage by using latent heat during phase change. The phase change is typically phase change between a solid and a liquid, and the phase change temperature is typically a melting point (solidifying point). T₁ and T₃ are values different from each other.

The first heat storage layer 12 may be a layer that is constituted only by the first latent heat storage material 12a and the third latent heat storage material 12b, or may be a layer that further includes another component. Examples of the other component include a thermoplastic resin and the like. As a specific configuration of the first heat storage layer 12, description for the first heat storage layer 10 in the first embodiment is quoted. More specific examples include a configuration in which an inorganic heat storage material is used as the first latent heat storage material 12a, a material obtained by granulating the first latent heat storage material 12a through capsulation or micro-gelation is dispersed in the third latent heat storage material 12b that is a gel-like organic heat storage material (for example, a paraffin gel). An inorganic heat storage material may be used as the third latent heat storage material 12b, and an organic heat storage material that is granulated through capsulation or micro-gelation or a gel-like organic heat storage material may be used as the first latent heat storage material 12a.

For example, the first heat storage layer 12 may be a continuous layer that is formed to extend over a rear surface side of the solar cell module, but the solar cell module may include partially a region in which the first heat storage layer 12 is not provided on the rear surface side. However, it is preferable that the first heat storage layer 12 exists at least immediately below the solar cell 1 from the viewpoint of efficiency of heat absorption from the solar cell 1. For example, the thickness of the first heat storage layer 12 may be approximately 0.1 to 100 mm.

For example, a weight ratio (the first latent heat storage material 12a/the third latent heat storage material 12b) between the first latent heat storage material 12a and the third latent heat storage material 12b in the first heat storage layer 12 is 30/70 to 70/30, and preferably 40/60 to 60/40.

Even in the solar cell module according to this embodiment which is provided with the first heat storage layer 12 including two kinds of latent heat storage materials of the first latent heat storage material 12a and the third latent heat storage material 12b, as is the case with the fourth embodiment, it is possible to obtain the effect of appropriately suppressing temperature rising of the solar cell module both in summer and in winter (that is, over a year).

In addition, when any one of the first latent heat storage material 12a and the third latent heat storage material 12b is set to use an inorganic heat storage material (a hydrate of an inorganic salt and the like), it is possible to further suppress flammability in comparison to a case where the heat storage material is constituted only by the organic heat storage material. In a configuration in which a heat storage material obtained through capsulation of the hydrate of the inorganic salt is dispersed in an organic heat storage material, it is possible to prevent water from being evaporated due to breakage of a film of the capsule.

In an example of this embodiment, substantially, only the first latent heat storage material 12a plays a role of absorbing heat in winter, and both of the first latent heat storage material 12a and the third latent heat storage material 12b play a role of absorbing heat in summer.

With regard to a more specific configuration of the first heat storage layer 12, for example, the first heat storage layer 12 may have a structure in which the first latent heat storage material 12a that is granulated is dispersed in the third latent heat storage material 12b. As the granular first latent heat storage material 12a, as illustrated in Fig. 10, a granular capsule, in which a latent heat storage material 12a-1 that is the same as the first latent heat storage material in the fourth embodiment is covered with a film 12a-2 of another latent heat storage material, may be used. For example, a particle size of the granular capsule is approximately 1 to 10 mm. Examples of a material that forms the film include a gel of an algic acid and divalent metal ions, a gel of pectin and divalent metal ions, a double-network gel to be described later, and the like.

A surface treatment may be performed on the first latent heat storage material 12a (for example, a capsule) to enhance affinity with the third latent heat storage material 12b. Examples of the surface treatment include a modification treatment of applying lipophilicity to a surface, and examples of a modifying agent in this case include a non-ionic surfactant such as sorbitan monolaurate.

On the other hand, it is preferable that the third latent heat storage material 12b is constituted by a gel-like heat storage material so as to fix the first latent heat storage material 12a in a dispersed state. Examples of the gel-like heat storage material include a gelated organic heat storage material such as gelated paraffin (paraffin gel). Further, a double-network to be described later may be used. In addition, the term "gel-like" in this specification represents a state which does not have flowability but in which plastic deformation occurs when a pressure is applied.

The third latent heat storage material 12b may be set as a granular capsule, and the granular capsule may be dispersed in the first latent heat storage material 12a that is an inorganic heat storage material.

An example of the gelated inorganic heat storage material is a gelated inorganic heat storage material (water-based gel-like inorganic heat storage material) that includes water. Typically, a water-based gel-like inorganic heat storage material contains a large amount of water, and thus the weight (heat storage material transportation weight) of the solar cell module tends to increase when being transported to a manufacturing site (including a site where the solar cell module is installed, the same shall apply hereinafter). To solve the problem, it is preferable to use a dried microgel. The dried microgel does not include water or substantially includes no water, it is possible to greatly reduce the heat storage material transportation weight, and it is possible to enhance transportation efficiency. It is possible to easily prepare the gel-like inorganic heat storage material on the spot such as at a site of manufacturing the solar cell module by mixing the dried microgel, the heat storage material, and water with each other. As described above, in a case where the dried microgel is prepared, the dried microcell and the heat storage material (first latent heat storage material and the like) are transported to the spot, the dried microgel, the heat storage material, and water are mixed on the spot to prepare the gel-like heat storage material such as the gel-like inorganic heat storage material that includes the microgel and the heat storage material, and then the solar cell module is manufactured on the spot, it is possible to greatly reduce the transportation cost, and the manufacturing cost of the solar cell module.

The dried microgel can be prepared, for example, by a method including 1) a process of preparing a microgel, 2) a process of removing a surfactant (an emulsifier) that exists on a surface of the microgel, and 3) a process of drying the microgel after removal of the surfactant. For example, the microgel in 1) may be obtained by polymerizing a dispersed phase (water phase) contained in W/O emulsion of water-in-oil. The W/O emulsion may be appropriately prepared through emulsification by using an SPG (shirasu porous glass) film. For example, a microgel, which is dispersed in a continuous phase, may be obtained by thermally polymerizing a dispersed phase (water phase) dispersed in the continuous phase (organic phase). For example, the dispersed phase includes an amide monomer, a crosslinking agent, a thermal polymerization initiator, a reaction promoter, and water. For example, the continuous phase includes an organic solvent such as kerosene, and a surfactant (emulsifier). The surfactant is appropriately selected in accordance with the polarity of an organic solvent. For example, in a case where the organic solvent is kerosene, polyethyleneglycerin condensed ricinoleic acid ester (PGPR, also abbreviated as polyricinoleate) can be used. According to the emulsifying method using the SPG film, it is possible to easily control a particle size of the microgel, for example, in a range of 1 to 50 µm through adjustment of a pore size of the film. In a case of spherical gel, a swelling speed is proportional to the square of the particle size. Accordingly, as the particle size of the dried microgel is small, it is possible to prepare the gel-like inorganic heat storage material from the dried microgel and the heat storage material in a short time.

The phase change temperature T₁ of the first latent heat storage material 12a may be approximately 30°C to 40°C (for example, equal to or higher than 30°C and lower than 40°C), and preferably approximately 32°C to 37°C (for example, 35°C). The phase change temperature T₃ of the third latent heat storage material 12b may be approximately 40°C to 65°C, preferably approximately 45°C to 60°C, and more preferably 45°C to 55°C (for example, 55°C).

As described above, it is preferable that the phase change temperatures T₁ and T₃ are set to temperatures different from each other, and more preferably temperatures satisfying a relationship of T₁ < T₃. In addition, as is the case with the second and third embodiments, it is preferable that T₁ and T₃ are appropriately selected on the basis of an environment in which the solar cell module is installed such as the ambient temperature at a site at which the solar cell module is installed, a temperature difference between day and night at the installation site, and an average wind speed. For example, it is preferable that T₁ and T₃ are higher than the highest ambient temperature at night in summer so that the first latent heat storage material 12a and the third latent heat storage material 12b return to a solid state at night through heat dissipation even in summer.

In addition, as is the case with (b) in the second embodiment, it is preferable that T₁ is lower than the highest temperature of the solar cell group, which is reached in daytime in summer, so that the first latent heat storage material 12a can absorb heat of the solar cell 1. Further, it is preferable that T₁ is lower than the highest temperature of the solar cell group, which is reached in daytime in winter, so as to obtain the effect of suppressing temperature rising of the solar cell module even in winter. In addition, as is the case with (a) of the second embodiment, it is preferable that T₃ is lower than the highest temperature of the solar cell group, which is reached in daytime in summer, so that the second latent heat storage material 12b can absorb heat of the solar cell 1.

### <Sixth Embodiment>

A solar cell module of this embodiment has the same configuration as in the first embodiment except that a layer (a sheet, a film, or the like) constituted by a double network gel and a first latent heat storage material is used as the first heat storage layer 10. The double network gel is a polymer gel having two kinds of independent polymer network structures including a polymer network structure of a brittle gel, and a polymer network structure of a stretchable gel. Examples of a polymer that constitutes the brittle gel include polyacrylamide sulfonate, and examples of a polymer that constitutes the stretchable gel include polyacrylamide.

According to the first heat storage layer 10 including the double network gel that has high strength and is similar to an elastomer, it is possible to lower thermal contact resistance between the first heat storage layer 10 and the back cover 4, and thus it is possible to further enhance the temperature-rising suppressing effect. As a result, according to this embodiment, the thermal-contact-resistance reducing layer is not necessarily used.

In addition, the layer, which is constituted by the double network gel according to this embodiment, may be used as a part of the heat storage layer and also used as the thermal-contact-resistance reducing layer, and the heat storage layer according to the above-described other embodiments may be laminated on the layer.

The double network gel may be prepared as a dried microgel by the above-described method. In a case where the double network gel is transported to a spot such as a manufacturing site of the solar cell module in the state of dried microgel, a gel-like heat storage material including the microgel that is the double network gel and the heat storage material (first latent heat storage material or the like) is prepared at the spot, and then the solar cell module is manufactured on the spot, it is possible to greatly reduce the transportation cost and the manufacturing cost of the solar cell module.

### <Seventh Embodiment>

A solar cell module of this embodiment has the same configuration as in the first embodiment except that a layer (a sheet, a film, or the like), which is constituted by a nano-composite gel and a first latent heat storage material, is used as the first heat storage layer 10. The nano-composite gel is a polymer gel obtained in combination of clay and a polymer. The clay mentioned here is a clay mineral that is dispersed in water in a thin sheet shape having a size of several tens of nm, and a representative thereof pertains to a group called smectite. Specific examples of smectite include montmorillonite that is a natural material, and hectorite, laponite, and saponite which are synthetic materials. The NC gel has a structure in which a polymer chain (for example, poly(N-isoprolylacrylamide)) is crosslinked between clays which function as a two-dimensional physical crosslinking plane. The NC gel can be obtained by allowing a monomer that forms the polymer chain, a polymerization initiator (for example, potassium persulate), and a polymerization promoter (for example, tetramethylethylene diamine) to react with each other in a clay-dispersed solution in the vicinity of room temperature for radical thermal polymerization.

According to the first heat storage layer 10 that is constituted by a high-toughness nano-composite gel, it is possible to lower the thermal contact resistance between the first heat storage layer 10 and the back cover 4, and thus it is possible to further enhance the temperature-rising suppressing effect. As a result, according to this embodiment, the thermal-contact-resistance reducing layer is not necessarily used.

In addition, the layer, which is constituted by the nano-composite gel according to this embodiment, may be used as a part of the heat storage layer, and also used as the thermal-contact-resistance reducing layer, and the heat storage layer according to the above-described other embodiments may be laminated on the layer.

The nano-composite gel may be prepared as a dried mircrogel by the above-described method. In a case where the nano-composite gel is transported to a spot such as a manufacturing site of the solar cell module in the state of dried microgel, a gel-like heat storage material including the microgel that is the nano-composite gel and the heat storage material (first latent heat storage material or the like) is prepared at the spot, and then the solar cell module is manufactured on the spot, it is possible to greatly reduce the transportation cost and the manufacturing cost of the solar cell module.

### <Eighth Embodiment>

A solar cell module of this embodiment is a support-structure-attached solar cell module that further includes a support structure configured to fix the solar cell module to, for example, the ground. As described above, heat absorbed by the heat storage layer can be dissipated at night. In the support-structure-attached solar cell module of this embodiment, the support structure can be used for heat dissipation. An example of the support-structure-attached solar cell module of this embodiment is illustrated in Fig. 11. The support-structure-attached solar cell module illustrated in Fig. 11 includes a solar cell module 30 including the first heat storage layer 10, and a support structure 40 that supports the solar cell module 30. The support structure 40 includes a pile 50 that is a base portion embedded in the ground 60, and the pile 50 is embedded in the ground 60 to fix the solar cell module 30 on the ground. For example, the pile 50 may be a screw pile (spiral pile). According to this, it is possible to fix the solar cell module 30 to a soft ground appropriately.

When using the support structure 40 including the above-described pile base, it is possible to promote heat dissipation of the heat storage layer at night. That is, when heat exchange is realized between the pile 50 that is a base portion of the support structure 40 and the first heat storage layer 10 (or the first heat storage layer and the second heat storage layer in a case of further including the second heat storage layer) of the solar cell module main body 30 (for example, the pile 50 and the solar cell module main body 30 are connected to each other with a heat conductive member), it is possible to transfer shallow underground heat (cold heat) that is lower than an ambient temperature to the solar cell module 30 by using the pile 50. Accordingly, it is possible to promote heat dissipation of the first heat storage layer 10 (or the first heat storage layer and the second heat storage layer) at night. The above-described heat dissipation using the underground heat is particularly advantageous in a case where the solar cell module 30 is installed at a site where a temperature difference between day and night is small.

### (Photovoltaic Power Generation System)

A photovoltaic power generation system according to the invention includes the above-described solar cell module (for example, at least one solar cell module selected from the first to eighth embodiments and modification examples thereof) according to the invention. Hereinafter, the photovoltaic power generation system according to the invention will be described in detail with reference to an embodiment. The photovoltaic power generation system in this specification represents an apparatus that appropriately converts power output from the solar cell module and supplies the converted power to a grid interconnection, an electric apparatus, and the like.

### <Ninth Embodiment>

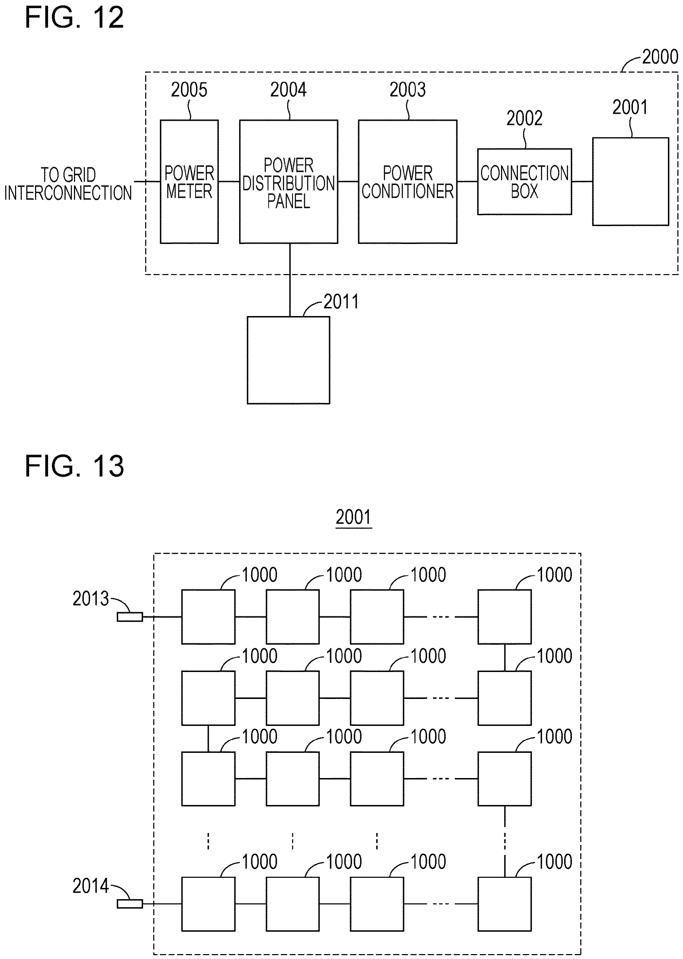

Fig. 12 is a schematic view illustrating a configuration of a photovoltaic power generation system 2000 according to this embodiment. As illustrated in Fig. 12, the photovoltaic power generation system 2000 includes a solar cell module array 2001, a connection box 2002, a power conditioner 2003, a power distribution panel 2004, and a power meter 2005. The solar cell module array 2001 is constituted by a plurality of solar cell modules 1000 as to be described later.

The photovoltaic power generation system 2000 may be provided with a function typically called "home energy management system (HEMS)". This system enables an individual home to contribute to power saving while monitoring a power using situation for each room.

The connection box 2002 is connected to the solar cell module array 2001. The power conditioner 2003 is connected to the connection box 2002. The power distribution panel 2004 is connected to the power conditioner 2003 and an electric apparatus 2011. The power meter 2005 is connected to the power distribution panel 2004 and the grid interconnection.

Description will be given of an operation of the photovoltaic power generation system 2000.

The solar cell module array 2001 generates DC power by converting sunlight into electricity, and supplies the DC power to the connection box 2002. The connection box 2002 receives the DC power generated by the solar cell module array 2001, and supplies the DC power to the power conditioner 2003. The power conditioner 2003 converts the DC power received from the connection box 2002 into AC power, and supplies the AC power to the power distribution panel 2004. Furthermore, a part or the entirety of the DC power received from the connection box 2002 may be supplied to the power distribution panel 2004 as the DC power without conversion into AC power.

The power distribution panel 2004 supplies at least any one of the power received from the power conditioner 2003 and commercial power received through the power meter 2005 to the electric apparatus 2011. In addition, when the AC power received from the power conditioner 2003 is greater than power consumption of the electric apparatus 2011, the power distribution panel 2004 supplies the AC power received from the power conditioner 2003 to the electric apparatus 2011. In addition, the remaining AC power is supplied to the grid interconnection through the power meter 2005.

In addition, when the AC power received from the power conditioner 2003 is smaller than the power consumption of the electric apparatus 2011, the power distribution panel 2004 supplies the AC power received from the grid interconnection and the AC power received from the power conditioner 2003 to the electric apparatus 2011.

The power meter 2005 measures power from the grid interconnection to the power distribution panel 2004 and measures power from the power distribution panel 2004 to the grid interconnection.

Next, description will be given of the solar cell module array 2001.

Fig. 13 is a schematic view illustrating an example of a configuration of the solar cell module array 2001 illustrated in Fig. 12. As illustrated in Fig. 13, the solar cell module array 2001 includes the plurality of solar cell module 1000 and output terminals 2013 and 2014.

The plurality of solar cell modules 1000 are arranged in an array and are connected to each other in series. Fig. 13 illustrates an arrangement in which the solar cell modules 1000 are connected to each other in series. However, the arrangement and the connection method are not limited thereto, and the solar cell modules 1000 may be arranged to be connected to each other in parallel, or an arrangement employing a combination of a serial connection and a parallel connection is also possible. The number of the solar cell modules 1000, which are included in the solar cell module array 2001, may be set to any integer of two or greater.

The output terminal 2013 is connected to a solar cell module 1000 that is located at one end of the plurality of solar cell modules 1000 which are connected to each other in series. The output terminal 2014 is connected to a solar cell module 1000 that is located at the other end of the plurality of solar cell modules 1000 which are connected in series.

The solar cell module according to the invention is capable of suppressing temperature rising due to solar irradiation, and is capable of preventing the photoelectric conversion efficiency from deteriorating. Accordingly, the photovoltaic power generation system 2000 using the solar cell module is also capable of suppressing temperature rising due to solar irradiation, and is also capable of preventing the photoelectric conversion efficiency from deteriorating.

Note that the above description is an example, and the photovoltaic power generation system according to this embodiment may employ any configuration without limitation to the above description as long as at least one of the plurality of solar cell modules 1000 is the solar cell module (for example, any one of the solar cell modules selected from the first to eighth embodiments, and modifications thereof) according to the invention.

### <Tenth Embodiment>

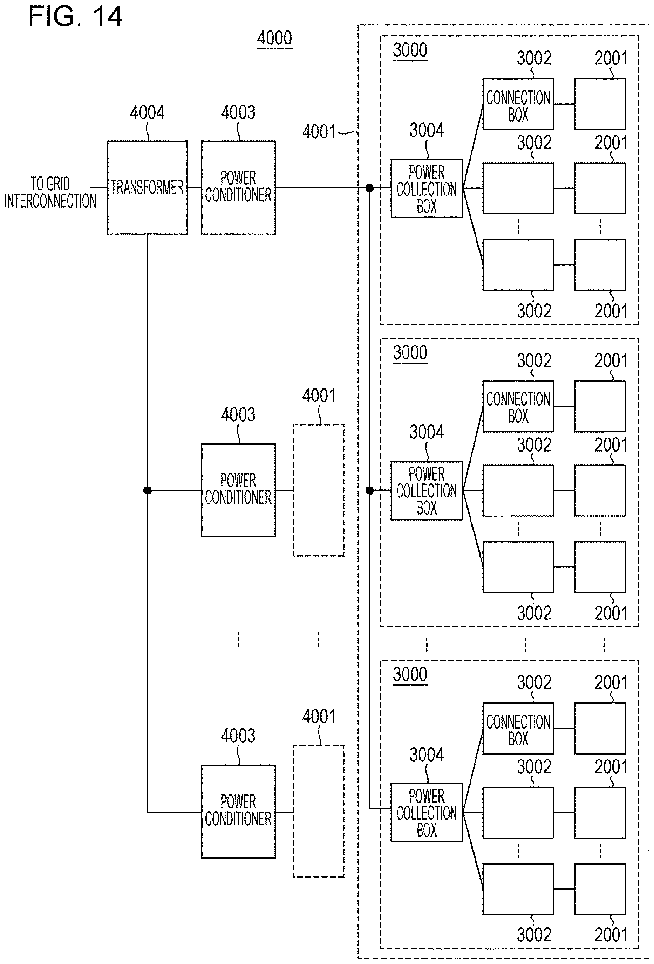

This embodiment is a photovoltaic power generation system having a scale greater than the scale of the photovoltaic power generation system according to the ninth embodiment. Fig. 14 is a schematic view illustrating a configuration of a photovoltaic power generation system 4000 according to this embodiment. As illustrated in Fig. 14, the photovoltaic power generation system 4000 includes a plurality of sub-systems 4001, a plurality of power conditioners 4003, and a transformer 4004. The photovoltaic power generation system 4000 is a photovoltaic power generation system having a scale greater than the scale of the photovoltaic power generation system 2000 illustrated in Fig. 12.

The plurality of power conditioners 4003 are connected to the respective sub-systems 4001. In the photovoltaic power generation system 4000, the number of the power conditioners 4003 and the sub-systems 4001 which are connected to the power conditioners 4003 may be set to any integer of two or greater. The transformer 4004 is connected to the plurality of power conditioners 4003 and a grid interconnection.

Each of the plurality of sub-systems 4001 includes a plurality of module systems 3000. The number of the module systems 3000 in the sub-system 4001 may be set to any integer of two or greater.

Each of the plurality of module systems 3000 includes a plurality of the solar cell module arrays 2001, a plurality of connection boxes 3002, and a power collection box 3004. The number of the connection boxes 3002 in the module system 3000 and the solar cell module arrays 2001 which are connected to the connection boxes 3002 may be set to any integer of two or greater.

The power collection box 3004 is connected to the plurality of connection boxes 3002. In addition, each of the power conditioners 4003 is connected to the plurality of power collection boxes 3004 in each of the sub-systems 4001.

Description will be given of an operation of the photovoltaic power generation system 4000.

The plurality of solar cell module arrays 2001 of the module system 3000 generate DC power by converting sunlight into electricity, and supply the DC power to the power collection box 3004 through the connection box 3002. A plurality of the power connection boxes 3004 in the sub-system 4001 supply the DC power to the power conditioner 4003. In addition, the plurality of power conditioners 4003 convert the DC power into AC power, and supply the AC power to the transformer 4004. The transformer 4004 converts the voltage of the AC power received from the plurality of power conditioners 4003, and supplies the AC power to the grid interconnection.

The solar cell module according to the invention is capable of suppressing temperature rising due to solar irradiation and is capable of preventing the photoelectric conversion efficiency from deteriorating. Accordingly, the large-scaled photovoltaic power generation system 4000 using the plurality of solar cell modules is also capable of suppressing temperature rising due to solar irradiation and is also capable of preventing the photoelectric conversion efficiency from deteriorating.

The photovoltaic power generation system 4000 may include at least one of the solar cell modules (for example, solar cell modules selected from the first to eighth embodiments and modification example thereof) according to the invention, and the entirety of the solar cell modules included in the photovoltaic power generation system 4000 is not necessarily the solar cell modules (photoelectric conversion elements) according to the invention. For example, the entirety of the solar cell modules included in a certain sub-system 4001 may be the solar cell modules according to the invention, and a part or the entirety of the solar cell modules included in another sub-system 4001 may not be the solar cell modules according to the invention.

The above-described embodiments are examples for carrying out the invention. The invention is not limited to the above-described embodiments, and can be executed by appropriately modifying the above-described embodiments in a range not departing from the gist of the invention. Reference Signs List

- 1: SOLAR CELL
- 2: INTERCONNECTOR
- 3: FRONT COVER
- 4: BACK COVER
- 5: FILLING MATERIAL
- 6: WIRE
- 7: FRAME
- 10, 12: FIRST HEAT STORAGE LAYER
- 11: HEAT STORAGE LAYER
- 11a: FIRST HEAT STORAGE LAYER
- 11b: SECOND HEAT STORAGE LAYER
- 12a: FIRST LATENT HEAT STORAGE MATERIAL
- 12a-1: LATENT HEAT STORAGE MATERIAL THAT BECOMES CORE OF CAPSULE
- 12a-2: FILM CONSTITUTED BY LATENT HEAT STORAGE MATERIAL
- 12b: THIRD LATENT HEAT STORAGE MATERIAL
- 20: THERMAL-CONTACT-RESISTANCE REDUCING LAYER
- 30: SOLAR CELL MODULE
- 40: SUPPORT STRUCTURE
- 50: PILE
- 60: UNDERGROUND
- 1000: SOLAR CELL MODULE
- 2000: PHOTOVOLTAIC POWER GENERATION SYSTEM
- 2001: SOLAR CELL MODULE ARRAY
- 2002: CONNECTION BOX
- 2003: POWER CONDITIONER
- 2004: POWER DISTRIBUTION PANEL
- 2005: POWER METER
- 2011: ELECTRIC APPARATUS
- 2013, 2014: OUTPUT TERMINAL
- 3000: MODULE SYSTEM
- 3002: CONNECTION BOX
- 3004: POWER COLLECTION BOX
- 4000: PHOTOVOLTAIC POWER GENERATION SYSTEM
- 4001: SUB-SYSTEM
- 4003: POWER CONDITIONER
- 4004: TRANSFORMER

## Claims

1. A solar cell module comprising:
a solar cell group in which a plurality of solar cells are arranged; and
a first heat storage layer that is disposed on a rear surface side of the solar cell group, wherein
the first heat storage layer is a layer that contains 80% by weight or greater of a latent heat storage material including a first latent heat storage material having a phase change temperature T₁.

2. The solar cell module according to Claim 1, wherein
the phase change temperature T₁ is 32°C to 37°C, or 45°C to 60°C.

3. The solar cell module according to Claim 1, further comprising
a second heat storage layer that is disposed on a rear surface side of the first heat storage layer, wherein
the second heat storage layer includes a second latent heat storage material having a phase change temperature T₂ different from the phase change temperature T₁, and
the phase change temperature T₁ is lower than the phase change temperature T₂.

4. The solar cell module according to Claim 3, wherein
the phase change temperature T₁ is 32°C to 37°C, and the phase change temperature T₂ is 45°C to 60°C.

5. The solar cell module according to Claim 1, wherein
the first heat storage layer is a layer that contains the first latent heat storage material and a third latent heat storage material having a phase change temperature T₃ different from the phase change temperature T₁.

6. The solar cell module according to Claim 5, wherein
the phase change temperature T₁ is lower than the phase change temperature T₃.

7. The solar cell module according to Claim 1, wherein
the first latent heat storage material is a gel-like heat storage material.

8. The solar cell module according to any one of Claims 1 to 7, further comprising
a support structure that supports the solar cell module, wherein
the support structure includes a base portion that is embedded in the ground, and
the first heat storage layer and the base portion are capable of exchanging heat from each other.

9. A method of manufacturing the solar cell module according to Claim 1, wherein the first heat storage layer includes a gel-like heat storage material including a microgel and the first latent heat storage material,
the method comprising,
a process of preparing a dried microgel obtained by drying the microgel,
a process of transporting the dried microgel to a manufacturing site of the solar cell module,
a process of preparing a gel-like heat storage material by mixing the dried microgel, the first latent heat storage material, and water at the manufacturing site, and
a process of preparing a solar cell module by using the gel-like heat storage material.

10. A photovoltaic power generation system comprising
the solar cell module according to any one of Claims 1 to 8.
